# EUROPÄISCHE PATENTSCHRIFT

(11) **EP 2 792 225 B1**
(45) Veröffentlichungstag und Bekanntmachung des Hinweises auf die Patenterteilung: **20.03.2019**
(21) Anmeldenummer: 12805943.3
(22) Anmeldetag: 05.12.2012
(51) Int. Cl.: H05K 7/14, H01H 36/00, H05K 5/06, G01D 11/24, H03K 17/945, H01H 9/02, H03K 17/95, B29C 70/72

(54) **ELEKTRISCHES SCHALTGERÄT**
ELECTRICAL SWITCHING DEVICE
COMMUTATEUR ÉLECTRIQUE

(30) Priorität: 14.12.2011 DE 102011121045
(43) Veröffentlichungstag der Anmeldung: 22.10.2014
(73) Patentinhaber: K.A. Schmersal Holding GmbH & Co. KG, 42279 Wuppertal (DE)
(72) Erfinder: BANASZEK, Matthias, 42117 Wuppertal (DE); WEBER, Jens, 44359 Dortmund (DE)
(74) Vertreter: Sparing Röhl Henseler
(86) Internationale Anmeldenummer: PCT/EP2012/005006
(87) Internationale Veröffentlichungsnummer: WO 2013/087160

(56) Entgegenhaltungen:
- EP-A2- 2 112 872
- FR-A1- 2 913 808
- US-A1- 2007 217 179
- US-A1- 2010 176 534
- US-A1- 2010 245 004
- US-B1- 7 724 540

## Beschreibung

Die Erfindung betrifft ein elektronisches Schaltgerät nach dem Oberbegriff des Anspruchs 1.

Aus US 2010/0245004 A1 ist ein elektronisches Schaltgerät mit einem Gehäuse nach dem Oberbegriff des Anspruchs 1 bekannt. Bei dem Schaltgerät ist ein Schalterträger mit einem Schaltergehäuse benachbart zu einem Betätigungsmagnetträger angeordnet, der mehrere Betätigungsmagnete aufnimmt. Die Nähe zu oder Entfernung von den Betätigungsmagneten in dem Betätigungsmagnetträger betätigt Ankermagnete innerhalb des Schaltergehäuses, um einen Schalterstromkreis zu öffnen und/oder zu schließen. Um die Zuverlässigkeit der elektrischen Kopplung zwischen den Ankermagneten und Elementen des Schalterstromkreises zu erhöhen, können der Schalterstromkreis, ein Ankerbaublock mit den Ankermagneten und ein Manipulationssicherungsschaltkreis in dem Schaltergehäuse mit einem Elektronik-Verguss- und/oder Verkapselungsmaterial fixiert sein.

Aus DE 81 16 313 ist ein Gehäuse für elektronische Schaltungen, insbesondere Näherungsschalter nach dem Oberbegriff des Anspruchs 1, bekannt. Durch die Kunststofffüllung wird eine ausreichende Montagestabilität erreicht. Ferner wird eine gute Pufferwirkung zum Ausgleich unterschiedlicher Wärmedehnungen zwischen Füllung und umschlossenen oder angrenzenden Gehäuse- und Schaltungsteilen erhalten. Nachteilig ist, dass die Justierung der Schaltungselemente in dem Gehäuse schwierig ist und es durch das Ausgießen mit einer Harzmasse zu Verlagerungen kommen kann.

Aus DE 42 44 994 B4 ist ein elektrisches Schaltgerät bekannt, bei dem die Füllung aus einem Schmelzkleber besteht. Schmelzkleber zeichnen sich aus durch eine absolute Abdichtung gegen Feuchtigkeit, hohe Wärmestandfestigkeit sowie sehr gute Verarbeitungseigenschaften. Nachteilig dabei ist, dass die Handhabung beim Füllen des Gehäuses mit Schmelzkleber hinsichtlich der korrekten Lage des Bauteileträgers schwierig ist.

Aufgabe der Erfindung ist es daher, ein elektronisches Schaltgerät zu schaffen, das die Lagetreue der vergossenen Leiterplatte in dem Gehäuse verbessert.

Diese Aufgabe wird durch die Merkmale des Anspruchs 1 gelöst.

Hierdurch wird ein elektronisches Schaltgerät geschaffen, bei dem die vergossene Leiterplatte mechanisch und elektrisch entkoppelt ist von dem Gehäuse, dabei aber lagebestimmt im Gehäuse angeordnet ist. Die elektrischen Spezifikationen in Bezug auf den Schaltabstand und insbesondere die Isolationseigenschaften sowie die Luft- und Kriechstrecken unter Einhaltungen der normativen Anforderungen (hier besonders UL) können besser erfüllt werden. Ferner sind solche Schaltgeräte hygienegerecht ausbildbar und sind besser einsetzbar unter allgemeinen Umwelteinflüssen, wie Reinigungsmittel UV-Strahlen, harte Wärme-/Kältewechsel, allgemein harte Umgebungsbedingungen, usw.

Diese Vorteile gelten insbesondere bei der Ausbildung des Schaltgerätes als Sicherheits-Magnetschalter, da die in einem Sensor als Schaltungsteile vorgesehenen Reed-Schalter lageabhängig auf Magnetfelder von Betätigern ansprechen. Die Justierung der Schaltungselemente im Gehäuse beeinflusst folglich deren Ansprechverhalten, das bei Schaltgeräten aber bezogen auf das Gehäuse vorteilhafterweise gleich ist, um individuelle Nachjustierungen der Montage von Sensor und Betätiger zu vermeiden. Eine Codierung des Betätigers und die damit verbundene spezielle Anordnung der Reed-Kontakte ist erforderlich, da der Schalter sonst nicht manipulationssicher wäre und somit nicht als Sicherheitsgerät eingestuft werden könnte.

Der rostartige Trägerkörper ist vorzugsweise eine Plattform für die Leiterplatte, die vom Gehäuse ausgeübte Druckspannungen beim Heißvergießen ausgleicht, so dass Positionsveränderungen der Leiterplatte gegenüber dem Gehäuse vermieden werden. Der Trägerkörper und die Leiterplatte sind vorzugsweise derart ausgebildet, dass sie mit der flüssigen Vergussmasse vor deren Aushärtung umspülbar sind, um ein möglichst vollständiges Eintauchen derselben zu erreichen. Der Trägerkörper ist vorzugsweise nach dem Aushärten der Kunststoffmasse ebenso wie die Leiterplatte mit den Schaltungsteilen im wesentlichen von dem Gehäuse mechanisch und thermisch entkoppelt, da durch ein Unterspülen des Trägerkörpers mit Kunststoffmasse beim Verfüllen vorzugsweise nur der Kontakt zum Gehäuse über bodenseitige Sockelelemente verbleibt.

Der elektronische Sicherheitsschalter kann der Schutzart IP 69 K entsprechen, was bedeutet, dass dieser dann hochdruckreinigerfest ist und in die typische Umgebungskonstruktion von Nahrungsmittelmaschinen einfügbar ist.

Weitere Ausgestaltungen der Erfindung sind der nachfolgenden Beschreibung und den Unteransprüchen zu entnehmen.

Die Erfindung wird nachstehend anhand des in den beigefügten Abbildungen dargestellten Ausführungsbeispiels der Erfindung erläutert.
Fig. 1 zeigt schematisch eine Explosionsdarstellung eines elektronischen Schaltgeräts ohne Füllung,

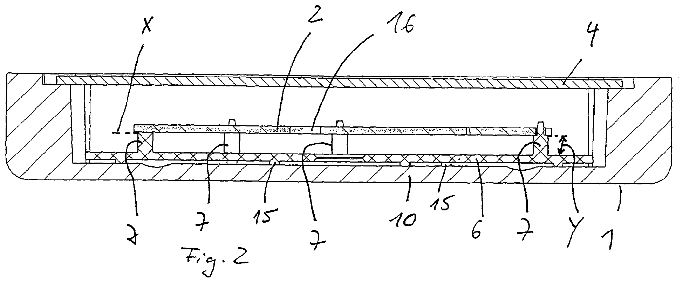

Fig. 2 zeigt schematisch einen Längsschnitt von Fig. 1 im zusammengesetzten Zustand.

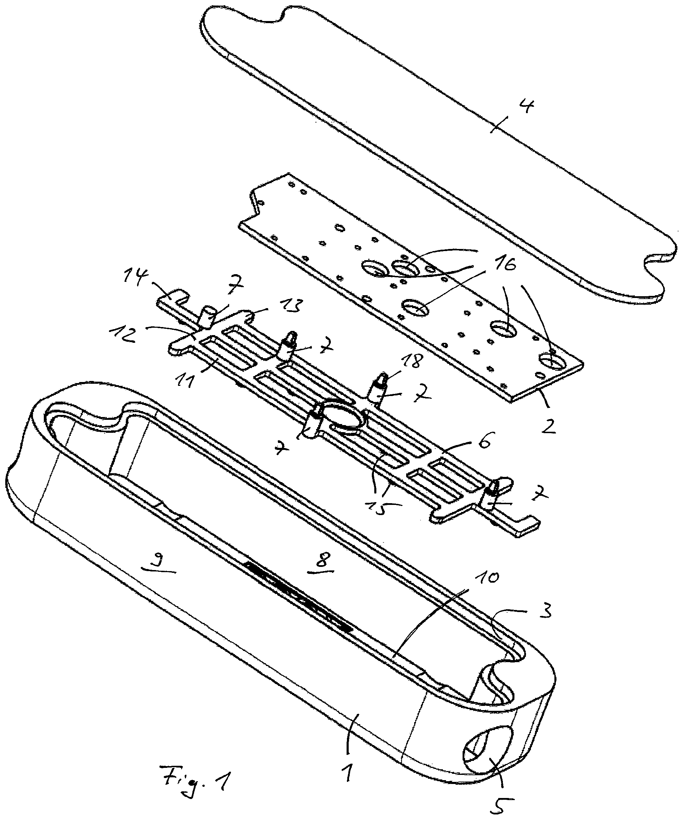

Wie Fig. 1 zeigt, betrifft die Erfindung ein elektronisches Schaltgerät mit einem Gehäuse 1, in dem mindestens eine Leiterplatte 2 mit Schaltungsteilen (nicht dargestellt) angeordnet ist. Das Gehäuse 1 ist mit mindestens einem eine Gehäuseöffnung 3 verschließenden Gehäusedeckel 4 und mit einer Kabeldurchführung 5 für ein Anschlusskabel (nicht dargestellt) ausgebildet. Im eingesetzten Zustand der Leiterplatte 2 in dem Gehäuse 1 ist dieses zur Fertigmontage versehen mit einer Füllung aus einer Kunststoffmasse (nicht dargestellt), die die Leiterplatte 2 mit den Schaltungsteilen umschließt.

Erfindungsgemäß wird die Leiterplatte 2 zum Vergießen mit einer Gussmasse im Gehäuse 1 geständert auf einem rostartigen Trägerkörper 6 angeordnet. Der rostartige Trägerkörper 6 weist dazu einzelne Stützen 7 auf, die eine Justierebene X abhängig von Höhen Y der Stützen 7 aufspannen und auf der die Leiterplatte 2 mit Abstand zu den Gehäusewänden 8, 9, 10 fixierbar ist zur lagebestimmten Anordnung der vergossenen Schaltungsteile in dem Gehäuse 1. Durch die Stützen 7 und deren vorzugsweise einstellbaren Höhen Y kann die Anordnung der Leiterplatte 2 insbesondere zu der Gehäusewand 10 justiert erfolgen, die in Bezug auf den Gehäusedeckel 4 einen Gehäuseboden bildet. Die auf der Leiterplatte 2 montierten Schaltungsteile, beispielsweise Reed-Schalter, besitzen dann eine bezogen auf das Gehäuse 1, insbesondere den Gehäuseboden 10, definierten Ansprechbereich und/ oder Schaltabstände für einen berührungslos arbeitenden Schalter zur Überwachung von beispielsweise Türen und Klappen.

Der rostartige Trägerkörper 6 ist vorzugsweise eine flache biegsame Konstruktion aus sich kreuzenden Stabelementen 11, 12 mit dünnen Querschnitten. Zur Positionierung des rostartigen Trägerkörpers 6 im Gehäuse 1 erstrecken sich Stabelemente 13, 14 als Druckstege zwischen den Gehäusewänden 8, 9. Der rostartige Trägerkörper 6 weist ferner vorzugsweise Sockelelemente 15 auf, die den Trägerkörper 6 beabstandet gegenüber dem Gehäuseboden 10 als Standfläche ausbilden. Hierdurch kann sichergestellt werden, dass die Leiterplatte 2 samt Trägerkörper 6 vergossen wird. Die Ständerfunktion des Trägerkörpers 6 geht in der ausgehärteten Vergussmasse verloren, da diese dann die mechanische und thermische Entkopplung der Leiterplatte 1 nebst Schaltungsteilen vom Gehäuse 1 vornimmt. Es existieren folglich keine Leiterplattenfixierungen am Gehäuse 1, da der zur Positionierung/Justierung der Leiterplatte 2 vorgesehene Trägerkörper 2 von der Vergussmasse umschmolzen wird. Kapillarkanäle zur Leiterplatte 2 werden so vermieden, da die Vergussmasse bis an den Gehäusewände 8, 9, 10 reicht.

Die Leiterplatte 2 weist vorzugsweise Öffnungen 16 auf für einen Durchtritt von Kunststoffmasse der Füllung beim Vergießen des Gehäuses 1. Die Leiterplatte 2 ist ferner vorzugsweise über Presssitzstifte 18 an den Stützen 7 fixierbar.

Gemäß einer nicht dargestellten Ausführungsform kann auf der Leiterplatte 2 mindestens eine Lichtquelle, beispielsweise eine Leuchtdiode montiert sein, die einen Schaltzustand anzeigt und über einen transparenten oder offenen Gehäuseabschnitt nach außen eine Anzeige vornehmen kann.

Das Gehäuse 1 ist vorzugsweise aus Metall, um beispielsweise den Hygieneanforderungen im Nahrungsmittelmaschinenbau zu genügen. Wird das Gehäuse 1 aus Edelstahl gefertigt, ist die Beständigkeit gegenüber Korrosion und Reinigungsflüssigkeiten gegeben. Das Gehäuse 1 besitzt dann ferner vorzugsweise eine schlanke Bauform mit feingeschliffener Oberfläche. Die feingeschliffene Oberfläche ist in erster Linie durch die Anforderungen an hygienegerechte Konstruktionen begründet. Bei der hygienegerechten Konstruktion ist unter anderem darauf zu achten, dass keine rauen Oberflächen, Sicken oder Kanten entstehen, da sich hier Verschmutzungen einlagern könnten und der Schalter dadurch schlecht zu reinigen wäre.

Die Abdichtung über die Kunststoffmasse erfolgt durch Verwendung einer Vergussmasse. Als Vergussmasse einsetzbar ist beispielsweise Macromelt von Henkel. Die Verarbeitungstemperaturen der Vergussmasse liegen dann beispielsweise unter 200°C.

Als Isolier- und Abdichtmittel können verschiedene Vergussmaterialien verwendet werden. Das Material muss beim Verguss allerdings möglichst flüssig sein, so dass es in die von der Leiterplatte 2 und dem Trägerkörper 6 belassenen Freiräume eingefüllt werden kann. Andererseits sollte das Material im ausgehärteten Zustand noch so elastisch sein, dass die Abdichtfunktion gefördert wird. Außerdem kann durch die Elastizität der Masse gewährleistet werden, dass Erschütterungen, die auf das Gehäuse einwirken, absorbiert werden.

Das Aufsetzen des Gehäusedeckels 4 kann während oder nach der Aushärtung der Vergussmasse bzw. der Füllung erfolgen. Die Montage des Deckels kann nach dem Aushärten der Vergussmasse folgende Schritte umfassen: Auftragen von Kleber auf den dafür vorgesehenen Rand des Gehäuses 1 und Einbringen des Gehäusedeckels 4 in eine dafür vorgesehene Gehäuseaussparung,

## Patentansprüche

1. Elektronisches Schaltgerät mit einem Gehäuse, in dem mindestens eine Leiterplatte mit Schaltungsteilen angeordnet ist, das Gehäuse mit mindestens einem eine Gehäuseöffnung verschließenden Gehäusedeckel und mit einer Kabeldurchführung für ein Anschlusskabel ausgebildet und versehen ist mit einer Füllung aus Kunststoffmasse, die die Leiterplatte mit den Schaltungsteilen umschließt, **dadurch gekennzeichnet, dass** die Leiterplatte (2) geständert auf einem rostartigen Trägerkörper (6) im Gehäuse (1) vergossen ist, wozu der rostartige Trägerkörper (6) einzelne Stützen (7) aufweist, die eine Justierebene (X) abhängig von Höhen (Y) der Stützen (7) aufspannen und auf der die Leiterplatte (2) mit Abstand zu den Gehäusewänden (8, 9, 10) fixierbar ist zur lagebestimmten Anordnung der vergossenen Schaltungsteile in dem Gehäuse (1).

2. Elektronisches Schaltgerät nach Anspruch 1, **dadurch gekennzeichnet, dass** der rostartige Trägerkörper (6) eine flache biegsame Konstruktion aus sich kreuzenden Stabelementen (11, 12) mit dünnen Querschnitten ist.

3. Elektronisches Schaltgerät nach Anspruch 2, **dadurch gekennzeichnet, dass** sich zur Positionierung des rostartigen Trägerkörpers (6) im Gehäuse (1) Stabelemente (13, 14) als Druckstege zwischen den Gehäusewänden (8, 9) erstrecken.

4. Elektronisches Schaltgerät nach einem der Ansprüche 1 bis 3, **dadurch gekennzeichnet, dass** der rostartige Trägerkörper (6) Sockelelemente (15) aufweist, die den Trägerkörper (6) beabstandet gegenüber einem Gehäuseboden (10) als Standfläche ausbilden.

5. Elektronisches Schaltgerät nach einem der Ansprüche 1 bis 4, **dadurch gekennzeichnet, dass** die Leiterplatte (2) Öffnungen (16) für einen Durchtritt von Kunststoffmasse der Füllung vor dem Aushärten aufweist.

## Claims

1. Electronic switching device having a housing in which at least one printed circuit board with circuit parts is arranged, the housing being designed with at least one housing cover, which closes a housing opening, and with a cable bushing for a connection cable and being provided with a filling made of plastic material which surrounds the printed circuit board with the circuit parts, **characterized in that** the printed circuit board (2) is encapsulated in the housing (1) in a supported manner on a grid-like carrier body (6), to which end the grid-like carrier body (6) has individual supports (7) which span an adjustment plane (X) depending on heights (Y) of the supports (7) and on which the printed circuit board (2) can be fixed at a distance from the housing walls (8, 9, 10) for a localized arrangement of the encapsulated circuit parts in the housing (1).

2. Electronic switching device according to Claim 1, **characterized in that** the grid-like carrier body (6) is a flat flexible structure comprising intersecting bar elements (11, 12) with thin cross sections.

3. Electronic switching device according to Claim 2, **characterized in that** bar elements (13, 14) extend between the housing walls (8, 9) as pressure webs for positioning the grid-like carrier body (6) in the housing (1).

4. Electronic switching device according to one of Claims 1 to 3, **characterized in that** the grid-like carrier body (6) has base elements (15) which arrange the carrier body (6) at a distance from a housing bottom (10) as base surface.

5. Electronic switching device according to one of Claims 1 to 4, **characterized in that** the printed circuit board (2) has openings (16) for the plastic material of the filling to pass through before curing.

## Revendications

1. Commutateur électronique avec un boîtier, dans lequel est agencée au moins une carte de circuit imprimé avec des parties de circuit, le boîtier est réalisé avec au moins un couvercle de boîtier fermant une ouverture de boîtier et avec un passage de câble pour un câble de raccordement et est doté d'un remplissage en masse de matière plastique, qui entoure la carte de circuit imprimé avec les parties de circuit, **caractérisé en ce que** la carte de circuit imprimé (2) est enrobée dans le boîtier (1) supportée sur un corps de support de type gril (6), ce pourquoi le corps de support de type gril (6) présente des supports individuels (7), qui définissent un plan d'ajustage (X) en fonction de hauteurs (Y) des supports (7) et sur lequel la carte de circuit imprimé (2) peut être fixée à distance des parois de boîtier (8, 9, 10) pour l'agencement dans une position déterminée des parties de circuit enrobées dans le boîtier (1).

2. Commutateur électronique selon la revendication 1, **caractérisé en ce que** le corps de support de type gril (6) est une construction flexible plane en éléments formant barreau (11, 12) qui se croisent à sections transversales minces.

3. Commutateur électronique selon la revendication 2, **caractérisé en ce que** des éléments formant barreau (13, 14) s'étendent en tant que barrettes de pression entre les parois de boîtier (8, 9) pour le positionnement du corps de support de type gril (6) dans le boîtier (1).

4. Commutateur électronique selon l'une quelconque des revendications 1 à 3, **caractérisé en ce que** le corps de support de type gril (6) présente des éléments formant socle (15), qui forment le corps de support (6) espacé par rapport à un fond de boîtier (10) en tant que surface d'appui.

5. Commutateur électronique selon l'une quelconque des revendications 1 à 4, **caractérisé en ce que** la carte de circuit imprimé (2) présente des ouvertures (16) pour un passage de masse de matière plastique du remplissage avant le durcissement.
